# EUROPÄISCHE PATENTANMELDUNG

(11) **EP 4 722 578 A1**
(43) Veröffentlichungstag der Anmeldung: **08.04.2026**
(21) Anmeldenummer: 25205975.3
(22) Anmeldetag: 01.10.2025
(51) Int. Cl.: F16M 11/10, F16M 13/02

(54) **VERSTELLEINHEIT FÜR EIN BEDIENTERMINAL, BEDIENTERMINAL FÜR EINEN UMWELTSIMULATIONSSCHRANK SOWIE UMWELTSIMULATIONSSCHRANK**

(30) Priorität: 02.10.2024 DE 102024128575
(71) Anmelder: Binder GmbH, 78532 Tuttlingen (DE)
(72) Erfinder: Storz, Ewald, 78604 Rietheim-Weilheim (DE); Urtic, Ante, 78087 Mönchweiler (DE); Leidolt, Richard, 78224 Singen (DE)
(74) Vertreter: Westphal, Mussgnug & Partner Patentanwälte mbB

(57) **Zusammenfassung**

Verstelleinheit (14) für ein Bedienterminal (10) umfassend
• ein an einem ersten Klappelement (18) angeordnetes und mindestens eine Rastausnehmung (28) aufweisendes Rastelement (30), und
• ein an einem zweiten Klappelement (22) angeordnetes und in einer der mindestens einen Rastausnehmung (28) anordenbares Stützelement (32),

wobei die Verstelleinheit (14) einen Schieber (40) aufweist, der entlang einer Schiebeachse (42) verschiebbar ist, wobei der Schieber (40) in einer ersten Position derart anordenbar ist, dass die mindestens eine Rastausnehmung (28) für die Anordnung des Stützelements (32) geöffnet ist, und wobei der Schieber (40) in einer zweiten Position derart anordenbar ist, dass die mindestens eine Rastausnehmung (28) für die Anordnung des Stützelements (32) gesperrt ist,
sowie Bedienterminal (10) mit einer derartigen Verstelleinheit (14),
sowie Umweltsimulationsschrank (12) mit einem derartigen Bedienterminal (10).

## Beschreibung

Die Erfindung betrifft eine Verstelleinheit für ein Bedienterminal, ein Bedienterminal für einen Umweltsimulationsschrank sowie einen Umweltsimulationsschrank.

Umweltsimulationsschränke werden in vielen Bereichen der Naturwissenschaft und Technik eingesetzt, um bestimmte Klimabedingungen zu simulieren. Die Ein- und/oder Ausgabe zur Steuerung eines solchen Umweltsimulationsschranks erfolgt üblicherweise mittels eines an einer Außenseite des Umweltsimulationsschranks angeordneten Bedienterminals. Dabei weist das Bedienterminal typischerweise einen Bildschirm und/oder Bedientasten zum Austausch von Informationen zwischen einem Benutzer und dem Umweltsimulationsschrank auf.

Um eine möglichst gute Bedienbarkeit, insbesondere Lesbarkeit, des Bedienterminals zu erreichen, ist es Stand der Technik, das Bedienterminal in Abhängigkeit von Randbedingungen, wie dem Aufstellorts des Umweltsimulationsschranks oder der Körpergröße der Benutzer, geneigt anzubringen. Eine derartige Anordnung ist beispielsweise in WO 2004 062 157 A2 beschrieben. Um das Display eines Geräts an sich ändernde Randbedingungen anpassen zu können, ist es beispielsweise aus der EP 3 935 331 B1, der DE 10 2005 063 090 A1 oder der DE 100 54 912 A1 zudem bekannt, das Display verstellbar auszubilden. Die US 2001 0 052 741 A1 zeigt darüber hinaus eine Anordnung, bei der Rastpositionen in verschiedenen Neigungswinkeln vorgesehen sind.

Nachteilig an den bekannten Lösungen ist, dass sich die Displays entweder gar nicht feststellen lassen, oder bereits durch die Ausübung von Druck auf das Display aus ihrer Rastposition ausrücken lassen. Für den industriellen Einsatz, insbesondere von Umweltsimulationsschränken, bei dem die Bedienterminals einer häufigen Benutzung unterliegen und die Benutzer mitunter in Schutzkleidung arbeiten, sind die bekannten Lösungen daher ungeeignet.

Der Erfindung liegt daher die Aufgabe zugrunde, eine Vorrichtung bereitzustellen, mit der ein Bedienterminal geneigt an einem Gerät anordenbar ist, derart dass die Anordnung robust und einfach handhabbar ist und ein lange Lebensdauer aufweist. Der Erfindung liegt ferner die Aufgabe zugrunde, ein Bedienterminal mit einer derartigen Vorrichtung sowie einen Umweltsimulationsschrank mit einem entsprechenden Bedienterminal bereitzustellen.

Die Aufgaben werden erfindungsgemäß gelöst durch eine Verstelleinheit mit den Merkmalen des Patentanspruchs 1, ein Bedienterminal mit den Merkmalen des Patentanspruchs 14 sowie einen Umweltsimulationsschrank mit den Merkmalen des Patentanspruchs 15.

Vorteilhafte Ausgestaltungen und Weiterbildungen der Erfindung sind in den abhängigen Ansprüchen angegeben.

Eine erfindungsgemäße Verstelleinheit für ein Bedienterminal, umfasst ein erstes Klappelement, ein zweites Klappelement, eine Drehachse, um die das erste Klappelement und das zweite Klappelement relativ zueinander verdrehbar sind, ein an dem ersten Klappelement angeordnetes und mindestens eine Rastausnehmung aufweisendes Rastelement, und ein an dem zweiten Klappelement angeordnetes und in einer der mindestens einen Rastausnehmung anordenbares Stützelement. Durch die Anordnung des Stützelements in der mindestens einen Rastausnehmung kann das Stützelement in der mindestens einen Rastausnehmung abgestützt werden. Das Stützelement kann drehbar an dem zweiten Klappelement angeordnet sein.

Das erfindungsgemäße Verstelleinheit weist einen Schieber auf, der entlang einer Schiebeachse verschiebbar ist, wobei der Schieber in einer ersten Position derart anordenbar ist, dass die mindestens eine Rastausnehmung für die Anordnung des Stützelements geöffnet ist, und wobei der Schieber in einer zweiten Position derart anordenbar ist, dass die mindestens eine Rastausnehmung für die Anordnung des Stützelements gesperrt ist. Durch eine derartige Anordnung kann die mindestens eine Rastausnehmung definiert für die Anordnung des Stützelements freigegeben oder geschlossen werden. Dadurch kann eine belastbare Verstelleinheit für ein Bedienterminal bereitgestellt werden Der Schieber kann von der ersten Position in die zweite Position und umgekehrt entlang der Schiebeachse verschiebbar sein. In der ersten Position ist der Schieber vorzugsweise derart angeordnet, dass das Stützelement in die mindestens eine Rastausnehmung einbringbar ist. In der zweiten Position ist der Schieber vorzugsweise derart angeordnet, dass das Stützelement nicht in die mindestens eine Rastausnehmung einbringbar ist.

In einer bevorzugten Ausführungsform der Erfindung weist der Schieber einen ersten Mitnahmevorsprung und einen bezogen auf die Schiebeachse dem ersten Mitnahmevorsprung gegenüberliegend angeordneten zweiten Mitnahmevorsprung auf, wobei an dem ersten Mitnahmevorsprung das Stützelement zum Verschieben des Schiebers von der zweiten Position in die erste Position anordenbar ist, und/oder an dem zweiten Mitnahmevorsprung das Stützelement zum Verschieben des Schiebers von der ersten Position in die zweite Position anordenbar ist. Auf diese Weise kann der Schieber mittels des Stützelements verschiebbar sein. Insbesondere kann damit eine Drehbewegung der beiden Klappelemente relativ zueinander um die Drehachse ein Verschieben des Schiebers entlang der Schiebeachse bewirken.

Vorzugsweise weist der Schieber einen Grundkörper mit einer C-förmigen Aussparung auf, wobei der erste Mitnahmevorsprung und der zweite Mitnahmevorsprung jeweils durch ein Aussparungsende der Aussparung gebildet sind. So kann das Stützelement in der Aussparung vom zweiten Mitnahmevorsprung zum ersten Mitnahevorsprung bewegt werden.

Der Schieber kann mindestens eine Schieberausnehmung aufweisen, wobei in der ersten Position die mindestens eine Rastausnehmung und die mindestens eine Schieberausnehmung vorzugsweise miteinander fluchtend angeordnet sind. Dabei liegen vorzugsweise die mindestens eine Rastausnehmung und die mindestens eine Schieberausnehmung bei der Betrachtung der Anordnung quer zu der Schiebeachse in einer Flucht. Auf diese Weise kann die mindestens eine Rastausnehmung für die Anordnung des Stützelements in der mindestens einen Rastausnehmung geöffnet sein. Damit kann in der ersten Position des Schiebers das Stützelement gleichzeitig in der mindestens einen Rastausnehmung und der mindestens einen Schieberausnehmung angeordnet sein. Bevorzugt entspricht die Anzahl der mindestens einen Schieberausnehmung der Anzahl der mindestens einen Rastausnehmung. Besonders bevorzugt weist das Rastelement drei Rastausnehmungen auf, die entlang der Schiebeachse hintereinander angeordnet sind und jeweils die Merkmale der mindestens einen Rastausnehmung umfassen können. Dadurch können das erste Klappelement und das zweite Klappelement in drei verschiedenen Positionen zueinander festgestellt werden. Die Rastausnehmungen sind vorzugsweise identisch ausgebildet. Die Schieberausnehmungen können ebenfalls identisch ausgebildet sein.

Die mindestens eine Schieberausnehmung ist bezogen auf die Schiebeachse vorzugsweise zwischen dem ersten Mitnahmevorsprung und dem zweiten Mitnahmevorsprung angeordnet. Die mindestens eine Schieberausnehmung kann insbesondere in der C-förmigen Aussparung angeordnet sein.

Jede der mindestens einen Rastausnehmung kann eine Rastausnehmungskontur mit einem ersten Endabschnitt und einem zweiten Endabschnitt aufweisen, wobei der erste Endabschnitt senkrecht zu der Schiebeachse angeordnet ist und/oder der zweite Endabschnitt schräg zu der Schiebeachse angeordnet ist. Mit einer Mehrzahl von Rastausnehmungen, die entlang der Schiebeachse hintereinander angeordnet sind, kann der Schieber damit eine entlang der Schiebeachse angeordnete Sägezahnkontur aufweisen. Durch die Anordnung des ersten Endabschnitts senkrecht zur Schiebeachse kann das Stützelement an dem ersten Endabschnitt der mindestens einen Rastausnehmung abgestützt werden. Durch die Anordnung des zweiten Endabschnitts schräg zur Schiebeachse kann das Stützelement an dem zweiten Endabschnitt der mindestens einen Rastausnehmung aus der mindestens einen Rastausnehmung herausgleiten.

Die mindestens eine Schieberausnehmung kann eine Schieberausnehmungskontur aufweisen, die zumindest abschnittsweise geometrisch ähnlich zu der Rastausnehmungskontur ausgebildet ist. Die Schieberausnehmungskontur kann dabei insbesondere zentrisch gestreckt gegenüber der Rastausnehmungskontur ausgebildet sein, sodass in der ersten Position des Schiebers die mindestens eine Schieberausnehmung gegenüber der mindestens einen Rastausnehmungskontur zurückversetzt angeordnet ist. Dadurch kann ein definiertes Abstützen des Stützelements in der Rastausnehmung erreicht werden. Die Schieberausnehmungskontur kann entsprechend der Rastausnehmungskontur einen ersten Endabschnitt aufweisen, der kürzer als der erste Endabschnitt der Rastausnehmungskontur ausgebildet ist. Dadurch kann ein Verhaken des Stützelements vermieden werden.

Die mindestens eine Rastausnehmung ist vorzugsweise derart angeordnet, dass der erste Endabschnitt hin zum ersten Mitnahmevorsprung und der zweite Endabschnitt hin zum zweiten Mitnahmevorsprung orientiert ist. Damit ist vorzugsweise der erste Endabschnitt der Rastausnehmungskontur näher an erstem Mitnahmevorsprung angeordnet als der zweite Endabschnitt der Rastausnehmungskontur.

Das Rastelement weist vorzugsweise ein erstes Rastelementteil, ein zweites Rastelementteil und eine zwischen dem ersten Rastelementteil und dem zweiten Rastelementteil entlang der Schiebeachse verlaufende Schiebenut auf, in der der Schieber angeordnet ist. Jede der mindestens einen Rastausnehmung ist vorzugsweise in dem ersten Rastelementteil und in dem zweiten Rastelementteil angeordnet, sodass jede der mindestens einen Rastausnehmung vorzugsweise die Schiebenut schneidet.

In einer Weiterbildung der Erfindung weist das Rastelement und/oder der Schieber Hemmmittel zur Erhöhung der Reibung zwischen dem Rastelement und dem Schieber auf. Dadurch kann ein Verschieben des Schiebers in Situationen vermieden werden, in denen das Stützelement nicht in der mindestens einen Rastausnehmung bzw. der mindestens einen Schieberausnehmung angeordnet ist.

Vorzugsweise sind die Hemmmittel als an dem Schieber und/oder dem Rastelement angeordnete Hemmvorsprünge ausgebildet. Die Hemmmittel können insbesondere an einer gegenüber der Aussparung angeordneten Rückseite des Schiebers und/oder an einer seitlich zu der Aussparung angeordneten Seitenfläche des Schiebers angeordnet sein. Ebenfalls ist es denkbar, die Hemmmittel in der Schiebenut anzuordnen.

In einer bevorzugten Ausführungsform der Erfindung weist die Verstelleinheit einen, vorzugsweise als Blattfeder ausgebildeten, Niederhalter zum Führen des Stützelements auf. Damit kann das Stützelement zum Verschieben des Schiebers in der Aussparung gehalten werden. Außerdem kann dadurch in der ersten Position das Stützelement in der mindestens einen Rastausnehmung eingerastet werden. Der Niederhalter kann U-förmig ausgebildet und/oder zumindest abschnittsweise in der Aussparung angeordnet sein.

Zwischen dem Schieber und dem Niederhalter kann ein Luftspalt angeordnet sein. Dadurch kann die Verschiebekraft, die zum Verschieben des Schiebers erforderlich ist, unabhängig von der Rastkraft, die zum Ausrasten des Stützelements aus der mindestens einen Rastausnehmung erforderlich ist, eingestellt werden. Das Stützelement ist vorzugsweise als zwischen dem Niederhalter und dem Schieber angeordneter Bügel ausgebildet.

Ein erfindungsgemäßes Bedienterminal, insbesondere für einen Umweltsimulationsschrank, umfasst die zuvor beschriebene Verstelleinheit, wobei das erste Klappelement als ein Bedienteil und das zweite Klappelement als ein Basisteil des Bedienterminals ausgebildet ist. Das Bedienteil umfasst vorzugsweise eine Ein- und/oder Ausgabeeinheit zur Eingabe und/oder Ausgabe von Informationen bzw. Befehlen. Das Basisteil kann beispielsweise zur Anordnung des Bedienterminals an dem Umweltsimulationsschrank oder als Teil des Umweltsimulationsschranks ausgebildet sein. Das Bedienterminal kann somit geneigt an einem Umweltsimulationsschrank angeordnet werden.

Ein erfindungsgemäßer Umweltsimulationsschrank weist das zuvor beschriebene Bedienterminal auf.

Ein Ausführungsbeispiel der Erfindung wird anhand der nachfolgenden Figuren erläutert. Es zeigt:
- Figur 1: eine perspektivische Ansicht eines Ausführungsbeispiels eines Bedienterminals mit markiertem Detail A,
- Figur 2: eine Detailansicht des in Fig. 1 markierten Details A,
- Figur 3: eine perspektivische Ansicht des in Fig. 1 gezeigten Ausführungsbeispiels mit ausgeblendetem Niederhalter und markiertem Detail B,
- Figur 4: eine Detailansicht des in Fig. 2 markierten Details B,
- Figur 5: eine Schnittansicht des in Fig. 1 gezeigten Ausführungsbeispiels in einer ersten Stellung mit markiertem Detail C,
- Figur 6: eine Detailansicht des in Fig. 5 markierten Details C,
- Figur 7: eine Schnittansicht des in Fig. 1 gezeigten Ausführungsbeispiels in einer zweiten Stellung mit markiertem Detail D,
- Figur 8: eine Detailansicht des in Fig. 7 markierten Details D,
- Figur 9: eine Schnittansicht des in Fig. 1 gezeigten Ausführungsbeispiels in einer dritten Stellung mit markiertem Detail E,
- Figur 10: eine Detailansicht des in Fig. 9 markierten Details E,
- Figur 11: eine perspektivische Ansicht des Schiebers des in Fig. 1 gezeigten Ausführungsbeispiels,
- Figur 12: eine Explosionsansicht des in Fig. 1 gezeigten Ausführungsbeispiels,
- Figur 13: eine perspektivische Ansicht eines ersten Ausführungsbeispiels eines Umweltsimulationsschranks,
- Figur 14: eine perspektivische Ansicht eines zweiten Ausführungsbeispiels eines Umweltsimulationsschranks.

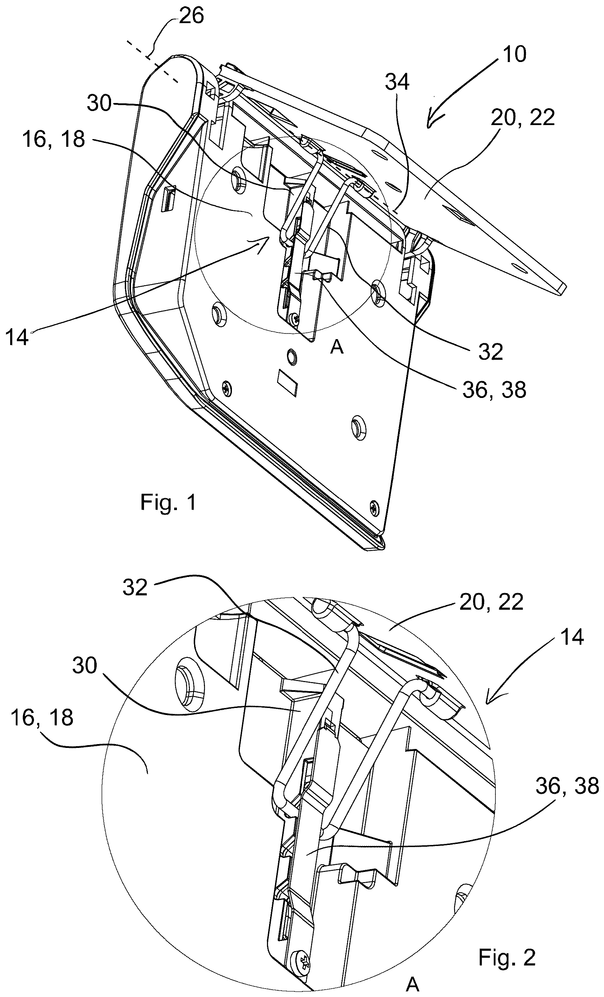

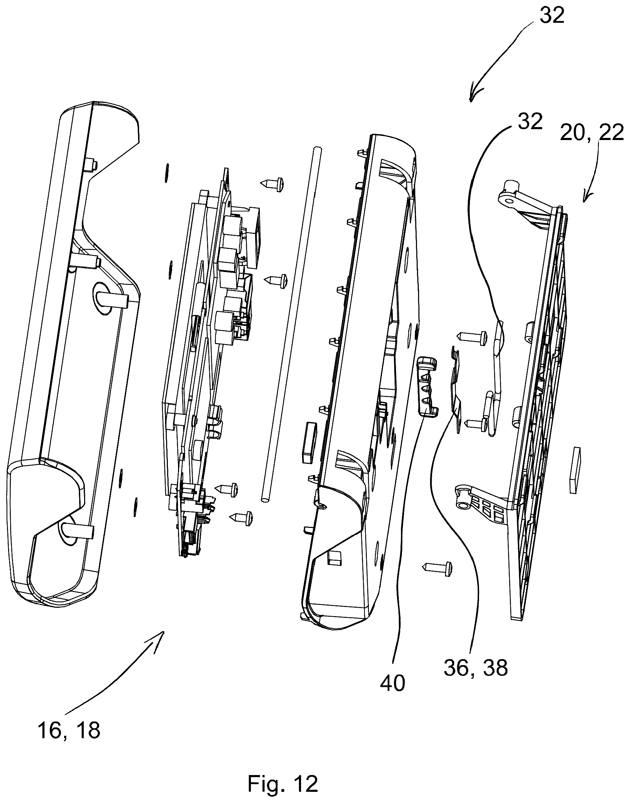

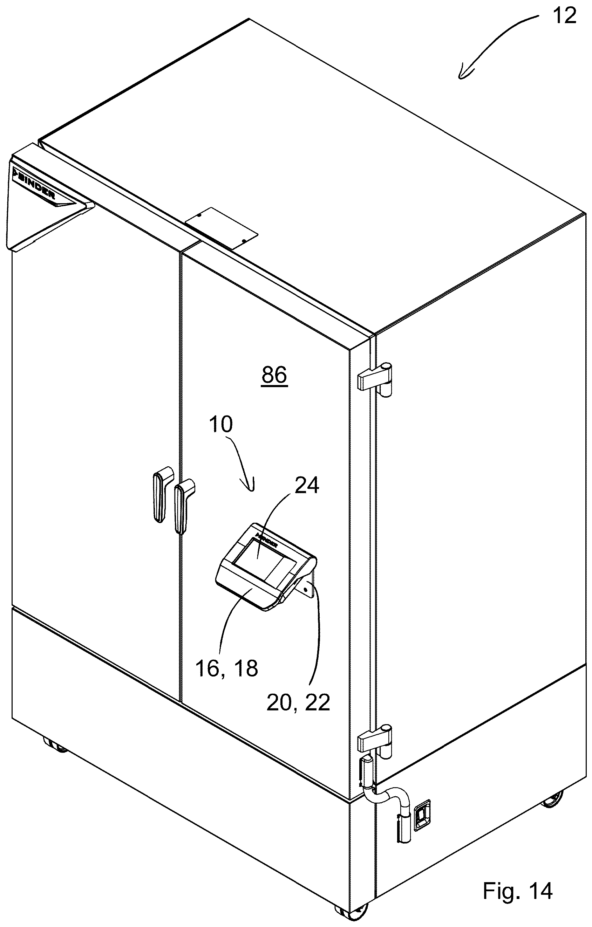

Die Figuren 1 bis 14 zeigen verschiedene Ausführungsbeispiele. Für gleiche und funktionsgleiche Teile werden die gleichen Bezugszeichen verwendet. Der Übersichtlichkeit halber werden nicht alle Bezugszeichen in jeder Figur verwendet.

Fig. 1 zeigt eine perspektivische Ansicht eines Bedienterminals 10 für einen Umweltsimulationsschrank 12 mit einer Verstelleinheit 14. Die Verstelleinheit 14 umfasst ein als Bedienteil 16 ausgebildetes erstes Klappelement 18 und ein als Basisteil 20 ausgebildetes zweites Klappelement 22. In den

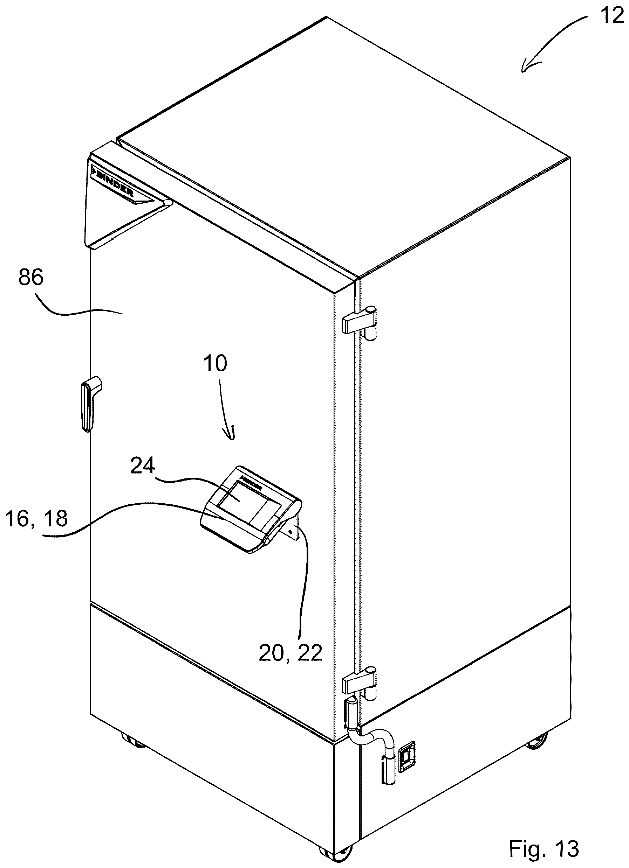

Fig. 13 u. 14 ist das Bedienteil 16 von vorne gezeigt. Dabei ist zu erkennen, dass das Bedienteil eine Ein- und/oder Ausgabeeinheit 24 zur Eingabe und/oder Ausgabe von Informationen bzw. Befehlen umfassen kann. Ebenso zeigen die Fig. 13 u. 14, dass das Basisteil 20 zur Anordnung des Bedienterminals 10 an dem Umweltsimulationsschrank 12 ausgebildet sein kann. Das Bedienterminal 10 kann mittels der Verstelleinheit 14 somit geneigt an dem Umweltsimulationsschrank 12 angeordnet werden.

Die Darstellung in Fig. 1 u. 2 zeigt, dass die Verstelleinheit 14 eine Drehachse 26 umfasst, um die das Bedienteil 16 und das Basisteil 20 relativ zueinander verdrehbar sind. Die Verstelleinheit 14 umfasst vorzugsweise ferner ein an dem Bedienteil 16 angeordnetes und mehrere Rastausnehmungen 28 aufweisendes Rastelement 30 sowie ein an dem Basisteil 20 angeordnetes und in jeder der Rastausnehmungen 28 anordenbares Stützelement 32. Durch die Anordnung des Stützelements 32 in einer der Rastausnehmungen 28 kann das Stützelement 32 in der jeweiligen Rastausnehmung 28 abgestützt werden. Das Stützelement 32 kann um eine Stützelementachse 34 drehbar an dem Basisteil 20 angeordnet sein.

Wie die Fig. 1 u. 2 weiter zeigen, kann die Verstelleinheit 14 einen als Blattfeder 36 ausgebildeten Niederhalter 38 aufweisen. Der Niederhalter 38 kann insbesondere an dem Rastelement 30 angeordnet sein.

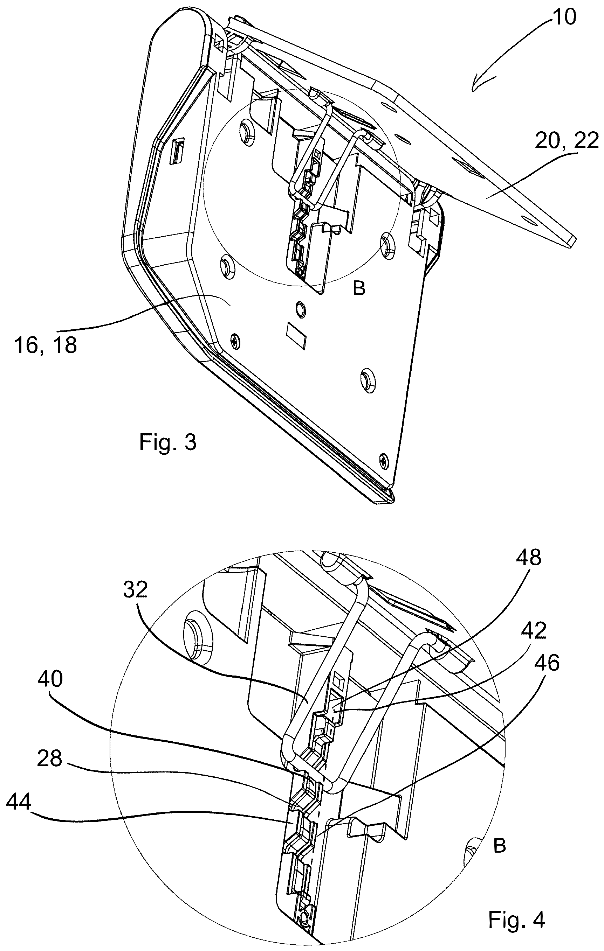

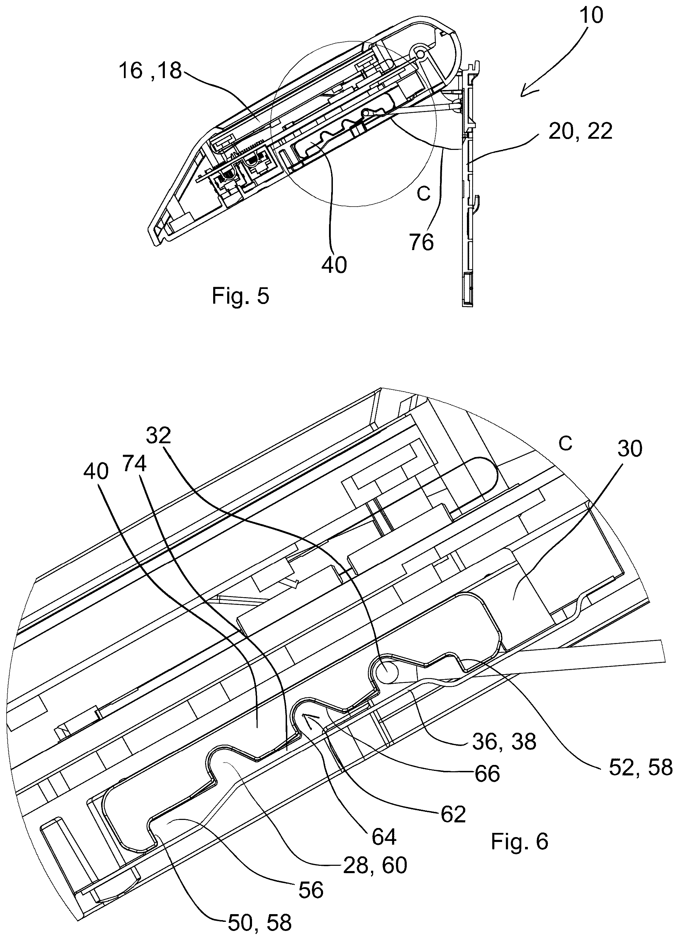

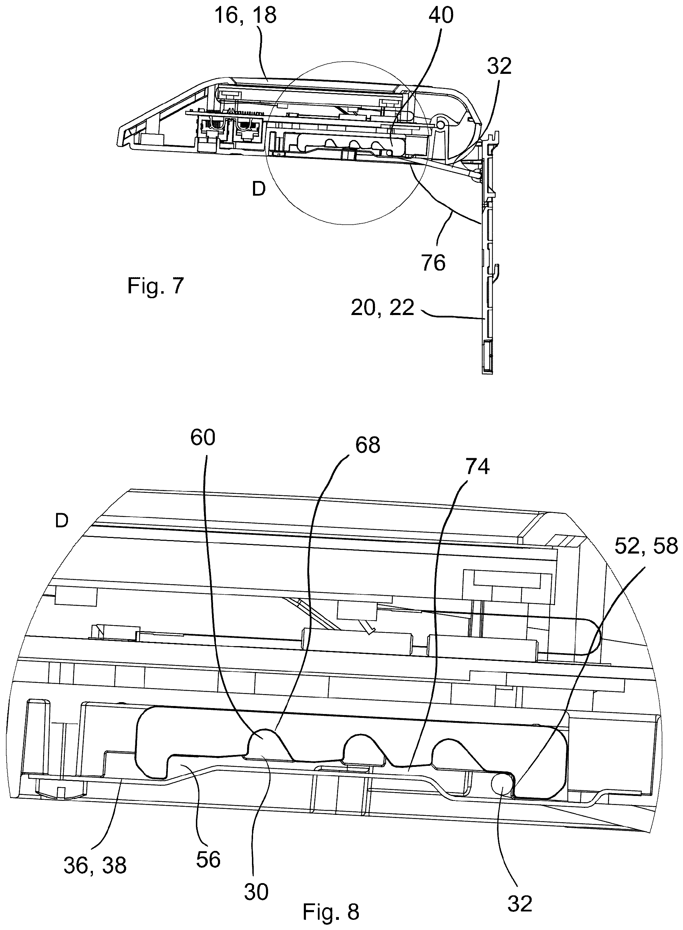

Die Fig. 3 u. 4 zeigen den Fig. 1 u. 2 entsprechende Darstellungen, in denen der Niederhalter 38 der Übersichtlichkeit halber ausgeblendet ist. Die Verstelleinheit 14 weist einen Schieber 40 auf, der insbesondere in Fig. 4 erkennbar ist. In den Fig. 5-10 ist das Bedienterminal 10 in unterschiedlichen Stellungen gezeigt. Daraus ist ersichtlich, dass der Schieber 40 in einer ersten Position derart anordenbar ist, dass die Rastausnehmungen 28 für die Anordnung des Stützelements geöffnet sind, sodass das Stützelement 32 in eine der Rastausnehmungen 28 einbringbar ist (Fig. 5-6 u. 9-10). In Fig. 7 u. 8 ist das Bedienterminal 10 in einer Stellung gezeigt, in der der Schieber 40 in einer zweiten Position derart angeordnet ist, dass die Rastausnehmungen 28 für die Anordnung des Stützelements 32 gesperrt sind, sodass das Stützelement 32 vorzugsweise in keine der Rastausnehmungen 28 einbringbar ist. Der Schieber 40 kann von der ersten Position in die zweite Position und umgekehrt entlang einer Schiebeachse 42 verschiebbar sein.

Wie insbesondere die Fig. 4 zeigt, kann das Rastelement 30 ein erstes Rastelementteil 44, ein zweites Rastelementteil 46 und eine zwischen dem ersten Rastelementteil 44 und dem zweiten Rastelementteil 46 entlang der Schiebeachse 42 verlaufende Schiebenut 48 aufweisen. Der Schieber 40 ist vorzugsweise in der Schiebenut 48 angeordnet. Die Rastausnehmungen 28 sind vorzugsweise derart in dem ersten Rastelementteil 44 und in dem zweiten Rastelementteil 46 angeordnet, dass jede der Rastausnehmung 28 die Schiebenut 48 rechtwinklig schneidet.

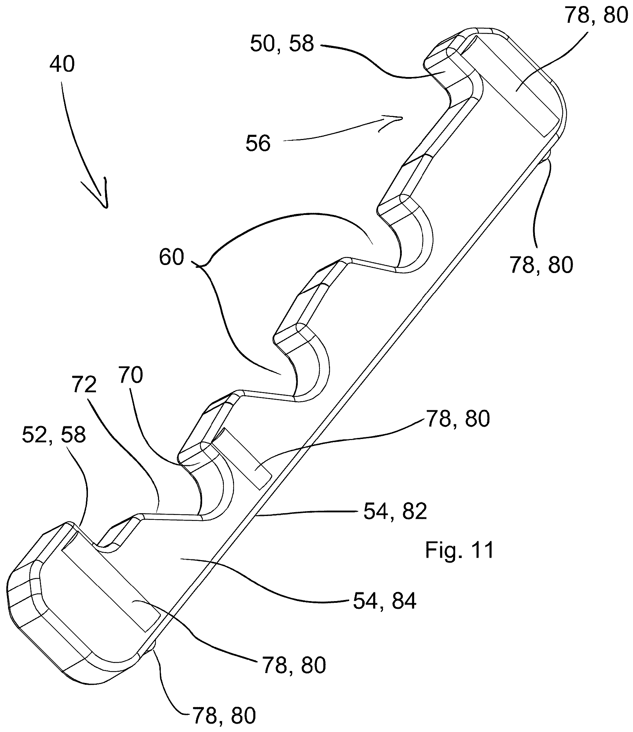

Eine Detailansicht des Schiebers 40 ist in Fig. 11 dargestellt. Die Fig. 11 zeigt, dass der Schieber 40 vorzugsweise einen ersten Mitnahmevorsprung 50 und einen bezogen auf die Schiebeachse 42 dem ersten Mitnahmevorsprung 50 gegenüberliegend angeordneten zweiten Mitnahmevorsprung 52 aufweist. Vorzugsweise ist an dem ersten Mitnahmevorsprung 50 das Stützelement 32 zum Verschieben des Schiebers 40 von der zweiten Position in die erste Position und an dem zweiten Mitnahmevorsprung 52 das Stützelement 32 zum Verschieben des Schiebers 40 von der ersten Position in die zweite Position anordenbar. Auf diese Weise kann der Schieber 40 mittels des Stützelements 32 verschiebbar sein.

Die Fig. 11 zeigt, dass der Schieber 40 einen Grundkörper 54 mit einer C-förmigen Aussparung 56 aufweisen kann, wobei der erste Mitnahmevorsprung 50 und der zweite Mitnahmevorsprung 52 jeweils durch ein Aussparungsende 58 der Aussparung 56 gebildet sind. So kann das Stützelement 32 in der Aussparung 56 vom zweiten Mitnahmevorsprung 52 zum ersten Mitnahevorsprung 50 bewegt werden.

Fig. 11 zeigt darüber hinaus, dass der Schieber 40 drei Schieberausnehmungen 60 aufweisen kann. Die Anzahl der Schieberausnehmungen 60 entspricht dabei vorzugsweise der Anzahl der Rastausnehmungen 28. In der in den Fig. 5-6 u. 9-10 dargestellten ersten Position sind die Rastausnehmungen 28 und die Schieberausnehmungen 60 vorzugsweise miteinander fluchtend angeordnet, sodass in den dort gezeigten Ansichten quer zu der Schiebeachse 42 die Rastausnehmungen 28 und die Schieberausnehmungen 60 in einer Flucht liegen. Damit sind die Rastausnehmungen 28 für die Anordnung des Stützelements 32 geöffnet, sodass, wie in den Fig. 5 u. 6 gezeigt, das Stützelement 32 gleichzeitig in einer der Rastausnehmungen 28 und einer der Schieberausnehmungen 60 angeordnet sein kann. Eine entsprechende Anordnung zeigen auch die Fig. 1-4. Die Schieberausnehmungen 60 sind bezogen auf die Schiebeachse 42 vorzugsweise zwischen dem ersten Mitnahmevorsprung 50 und dem zweiten Mitnahmevorsprung 52 in der C-förmigen Aussparung 56 angeordnet. Durch das Vorsehen dreier Rastausnehmungen 28 und dreier Schieberausnehmungen 60 können das Bedienteil 16 und das Basisteil 20 in drei verschiedenen Positionen zueinander festgestellt werden.

Die Darstellung in Fig. 6 veranschaulicht, dass jede der Rastausnehmungen 28 eine Rastausnehmungskontur 62 mit einem ersten Endabschnitt 64 und einem zweiten Endabschnitt 66 aufweisen kann, wobei vorzugsweise der erste Endabschnitt 64 senkrecht zu der Schiebeachse 42 und der zweite Endabschnitt 66 schräg zu der Schiebeachse 42 angeordnet ist. Durch die Mehrzahl der Rastausnehmungen 28, die entlang der Schiebeachse 42 hintereinander angeordnet sind, kann der Schieber 40 damit eine entlang der Schiebeachse 42 angeordnete Sägezahnkontur aufweisen. Wie anhand der Fig. 5 deutlich wird, kann durch die Anordnung des ersten Endabschnitts 64 senkrecht zur Schiebeachse 42 das Stützelement 32 an dem ersten Endabschnitt 64 abgestützt werden. Durch die Anordnung des zweiten Endabschnitts 66 schräg zur Schiebeachse 42 kann das Stützelement 32 an dem zweiten Endabschnitt 66 aus der jeweiligen Rastausnehmung 28 herausgleiten.

Die Ansicht in Fig. 11 zeigt, dass die Schieberausnehmungen 60 jeweils eine Schieberausnehmungskontur 68 aufweisen. Die Schieberausnehmungskontur 68 ist zumindest abschnittsweise geometrisch ähnlich zu der Rastausnehmungskontur 62 ausgebildet. Die Schieberausnehmungskontur 68 kann dabei insbesondere zentrisch gestreckt gegenüber der Rastausnehmungskontur 62 ausgebildet sein, sodass in der in Fig. 5 u. 6 gezeigten ersten Position des Schiebers 40 jede der Schieberausnehmungen 60 gegenüber der jeweils entsprechenden Rastausnehmungskontur 62 zurückversetzt angeordnet ist. Die Schieberausnehmungskontur 68 kann entsprechend der Rastausnehmungskontur 62 einen ersten Endabschnitt 70 und einen zweiten Endabschnitt 72 aufweisen, wobei der erste Endabschnitt 70 der kürzer als der erste Endabschnitt 64 der Rastausnehmungskontur 62 ausgebildet ist. Dadurch kann ein Verhaken des Stützelements 32 vermieden werden. Die Rastausnehmungen 28 sind vorzugsweise derart angeordnet, dass der erste Endabschnitt 70 hin zum ersten Mitnahmevorsprung 50 und der zweite Endabschnitt 72 hin zum zweiten Mitnahmevorsprung 52 orientiert ist.

Insbesondere in der Darstellung der Fig. 1 u. 2 sowie in der Detailansicht der Fig. 6, 8 u. 10 ist der Niederhalter 38 zum Führen des Stützelements 32 zu erkennen. Vorzugsweise ist der Niederhalter 38 derart angeordnet, dass er ausgehend von der in Fig. 6 gezeigten Stellung zum Verschieben des Schiebers 40 durch das Stützelement 32 angehoben werden muss. Mithilfe des Niederhalters 38 kann das Stützelement 32 zum Verschieben des Schiebers 40 in der C-förmigen Aussparung 56 gehalten werden. Außerdem kann in der ersten Position des Schiebers 40 durch das Vorhandensein des Niederhalters 38 das Stützelement in einer der Rastausnehmungen 28 eingerastet werden. Wie insbesondere die Schnittansichten der Fig. 6, 8 u. 10 zeigen, kann der Niederhalter 38 U-förmig ausgebildet und zumindest abschnittsweise in der Aussparung 56 angeordnet sein. Aus diesen Ansichten wird außerdem deutlich, dass der Niederhalter 38 einseitig am Ende der Schiebenut 48 mit einer Schraubverbindung am Rastelement 30 befestigt ist. Zwischen dem Schieber 40 und dem Niederhalter 38 kann ein Luftspalt 74 angeordnet sein. Das Stützelement 32 ist vorzugsweise als zwischen dem Niederhalter 38 und dem Schieber 40 angeordneter Bügel ausgebildet (siehe insbesondere Fig. 1 u. 2).

Anhand der in den Fig. 5 bis 10 gezeigten Stellungen lässt sich auch die grundsätzliche Funktionsweise der Verstelleinheit 14 erklären. Dabei wird die Annahme zugrunde gelegt, dass das Basisteil 20 fest im Raum angeordnet ist. In der in den Fig. 5 u. 6 gezeigten Stellung ist der Schieber 40 in der ersten Position und das Stützelement 32 in der obersten der Rastausnehmungen 28 angeordnet, sodass zwischen dem Bedienteil 16 und dem Basisteil 20 ein Klappwinkel 76 von größer 0°, vorzugsweise von ca. 60°, angeordnet ist. Durch manuelles Anheben des Bedienteils 16 derart, dass der Klappwinkel 76 weiter vergrößert wird, kann das Stützelement 32 gegen den Widerstand des Niederhalters 38 aus der Rastausnehmung 28 ausgerückt und an den zweiten Mitnahmevorsprung 52 angelegt werden.

Durch weiteres Vergrößern des Klappwinkels 76, vorzugsweise auf größer oder gleich 90°, durch weiteres Anheben des Bedienteils, kann der Schieber 40 entlang der Schiebeachse 42 in die zweite Position bewegt werden. Die entsprechende Stellung der Verstelleinheit 14 ist in den Fig. 7 u. 8 gezeigt. Durch das Anordnen des Schiebers 40 in der zweiten Position sind die Rastausnehmungen 28 durch den Schieber 40 gesperrt. Dies ermöglicht ein anschließendes Herunterklappen des Bedienteils 16, also Verkleinern des Klappwinkels 76, bei dem das Stützelement 76 die C-förmige Aussparung 56 des Schiebers 40 entlang bewegt wird, ohne dass das Stützelement 32 in einer der Rastausnehmungen 28 angeordnet wird.

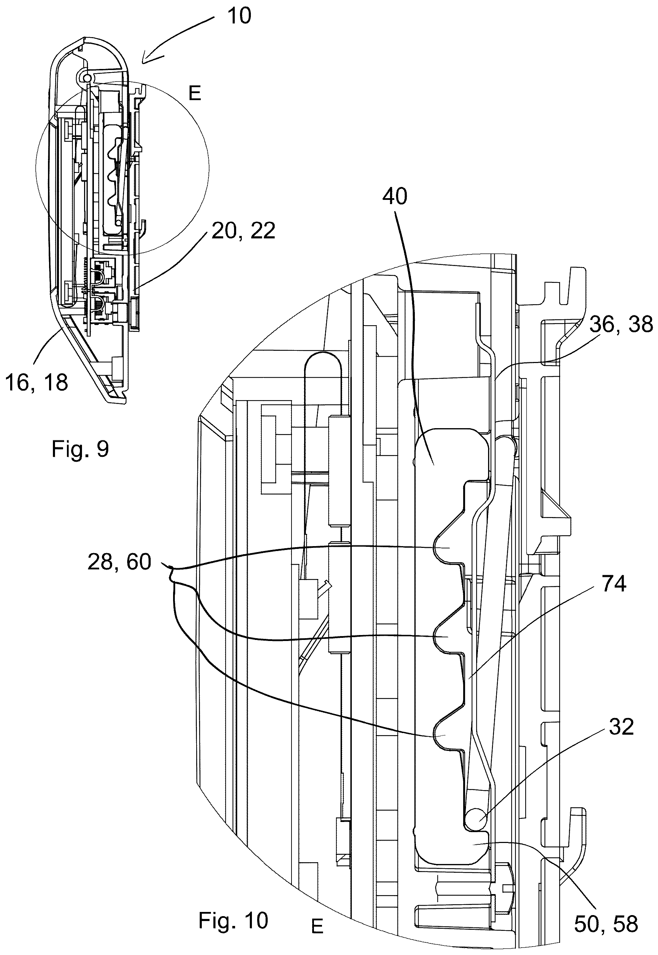

Bevor der Klappwinkel 76 beim Herunterklappen des Bedienteils 16 einen Wert von 0° erreicht, erreicht das Stützelement 32 dabei den ersten Mitnahmevorsprung 50. Ein weiteres Herunterklappen des Bedienteils 16 sorgt so dafür, dass der Schieber 40 durch das Stützelement 32 entlang der Schiebeachse 42 in die erste Position zurückgeführt wird, sodass die Rastausnehmungen 28 geöffnet sind (siehe Fig. 9 u. 10). Durch anschließendes Anheben des Bedienteils 16 kann das Stützelement 32 in einer der Rastausnehmungen angeordnet und das Bedienteil 16 damit angestellt werden.

Um ein ungewolltes Verschieben des Schiebers 40 zu verhindern, beispielsweise beim Entlangbewegen des Stützelements 32 an den gesperrten Rastausnehmungen 28, kann insbesondere der Schieber 40 als Hemmvorsprünge 78 ausgebildete Hemmmittel 80 zur Erhöhung der Reibung zwischen dem Rastelement 30 und dem Schieber 40 aufweisen. Wie in der Darstellung des Schiebers 40 in Fig. 11 gezeigt ist, können die Hemmvorsprünge insbesondere an einer gegenüber der Aussparung 56 angeordneten Rückseite 82 des Schiebers 40 und an einer seitlich zu der Aussparung 56 angeordneten Seitenfläche 84 des Schiebers 40 angeordnet sein.

Die Fig. 13 u. 14 zeigen jeweils ein Ausführungsbeispiel des Umweltsimulationsschranks 12, wobei das Bedienterminal 10 außen an einer Tür 86 des Umweltsimulationsschranks 10 angeordnet ist. Dabei ist erkennbar, dass das Basisteil 20 in unmittelbar an der Tür 86 anliegt.

### Bezugszeichenliste

- 10: Bedienterminal
- 12: Umweltsimulationsschrank
- 14: Verstelleinheit
- 16: Bedienteil
- 18: erstes Klappelement
- 20: Basisteil
- 22: zweites Klappelement
- 24: Ein- und/oder Ausgabeeinheit
- 26: Drehachse
- 28: Rastausnehmung
- 30: Rastelement
- 32: Stützelement
- 34: Stützelementachse
- 36: Blattfeder
- 38: Niederhalter
- 40: Schieber
- 42: Schiebeachse
- 44: erstes Rastelementteil
- 46: zweites Rastelementteil
- 48: Schiebenut
- 50: erster Mitnahmevorsprung
- 52: zweiter Mitnahmevorsprung
- 54: Grundkörper
- 56: Aussparung
- 58: Aussparungsende
- 60: Schieberausnehmung
- 62: Rastausnehmungskontur
- 64: erster Endabschnitt
- 66: zweiter Endabschnitt
- 68: Schieberausnehmungskontur
- 70: erster Endabschnitt
- 72: zweiter Endabschnitt
- 74: Luftspalt
- 76: Klappwinkel
- 78: Hemmvorsprung
- 80: Hemmmittel
- 82: Rückseite
- 84: Seitenfläche
- 86: Tür

## Patentansprüche

1. Verstelleinheit (14) für ein Bedienterminal (10) umfassend
• ein erstes Klappelement (18),
• ein zweites Klappelement (22),
• eine Drehachse (26), um die das erste Klappelement (18) und das zweite Klappelement (22) relativ zueinander verdrehbar sind,
• ein an dem ersten Klappelement (18) angeordnetes und mindestens eine Rastausnehmung (28) aufweisendes Rastelement (30), und
• ein an dem zweiten Klappelement (22) angeordnetes und in einer der mindestens einen Rastausnehmung (28) anordenbares Stützelement (32),
**dadurch gekennzeichnet, dass** die Verstelleinheit (14) einen Schieber (40) aufweist, der entlang einer Schiebeachse (42) verschiebbar ist, wobei der Schieber (40) in einer ersten Position derart anordenbar ist, dass die mindestens eine Rastausnehmung (28) für die Anordnung des Stützelements (32) geöffnet ist, und wobei der Schieber (40) in einer zweiten Position derart anordenbar ist, dass die mindestens eine Rastausnehmung (28) für die Anordnung des Stützelements (32) gesperrt ist.

2. Verstelleinheit nach Anspruch 1,
**dadurch gekennzeichnet, dass**
der Schieber (40) einen ersten Mitnahmevorsprung (50) und einen bezogen auf die Schiebeachse (42) dem ersten Mitnahmevorsprung (50) gegenüberliegend angeordneten zweiten Mitnahmevorsprung (52) aufweist, wobei an dem ersten Mitnahmevorsprung (50) das Stützelement (32) zum Verschieben des Schiebers (40) von der ersten Position in die zweite Position anordenbar ist, und/oder an dem zweiten Mitnahmevorsprung (52) das Stützelement (32) zum Verschieben des Schiebers (40) von der zweiten Position in die erste Position anordenbar ist.

3. Verstelleinheit nach Anspruch 2,
**dadurch gekennzeichnet, dass**
der Schieber (40) einen Grundkörper (54) mit einer C-förmigen Aussparung (56) aufweist, wobei der erste Mitnahmevorsprung (50) und der zweite Mitnahmevorsprung (52) jeweils durch ein Aussparungsende (58) der Aussparung (56) gebildet sind.

4. Verstelleinheit nach einem der vorhergehenden Ansprüche,
**dadurch gekennzeichnet, dass**
der Schieber (40) mindestens eine Schieberausnehmung (60) aufweist, wobei in der ersten Position die mindestens eine Rastausnehmung (28) und die mindestens eine Schieberausnehmung (60) miteinander fluchtend angeordnet sind.

5. Verstelleinheit nach Anspruch 4,
**dadurch gekennzeichnet, dass**
das die mindestens eine Schieberausnehmung (60) bezogen auf die Schiebeachse (42) zwischen dem ersten Mitnahmevorsprung (50) und dem zweiten Mitnahmevorsprung (52) angeordnet ist.

6. Verstelleinheit nach einem der vorhergehenden Ansprüche,
**dadurch gekennzeichnet, dass**
jede der mindestens einen Rastausnehmung (28) eine Rastausnehmungskontur (62) mit einem ersten Endabschnitt (64) und einem zweiten Endabschnitt (66) aufweist, wobei der erste Endabschnitt (64) senkrecht zu der Schiebeachse (42) angeordnet ist und/oder der zweite Endabschnitt (66) schräg zu der Schiebeachse (42) angeordnet ist.

7. Verstelleinheit nach Anspruch 6 und einem der Ansprüche 4 bis 5,
**dadurch gekennzeichnet, dass**
die mindestens eine Schieberausnehmung (60) eine Schieberausnehmungskontur (68) aufweist, die zumindest abschnittsweise geometrisch ähnlich zu der Rastausnehmungskontur (62) ausgebildet ist.

8. Verstelleinheit nach einem der Ansprüche 6 bis 7,
**dadurch gekennzeichnet, dass**
die mindestens eine Rastausnehmung (28) derart angeordnet ist, dass der erste Endabschnitt (64) hin zum ersten Mitnahmevorsprung (50) und der zweite Endabschnitt (66) hin zum zweiten Mitnahmevorsprung (52) orientiert ist.

9. Verstelleinheit nach einem der vorhergehenden Ansprüche,
**dadurch gekennzeichnet, dass**
das Rastelement (30) ein erstes Rastelementteil (44), ein zweites Rastelementteil (46) und eine zwischen dem ersten Rastelementteil (44) und dem zweiten Rastelementteil (46) entlang der Schiebeachse (42) verlaufende Schiebenut (48) aufweist, in der der Schieber (40) angeordnet ist.

10. Verstelleinheit nach einem der vorhergehenden Ansprüche,
**dadurch gekennzeichnet, dass**
das Rastelement (30) und/oder der Schieber (40) Hemmmittel (80) zur Erhöhung der Reibung zwischen dem Rastelement (30) und dem Schieber (40) aufweisen.

11. Verstelleinheit nach Anspruch 10,
**dadurch gekennzeichnet, dass**
die Hemmmittel (80) als an dem Schieber (40) und/oder dem Rastelement (30) angeordnete Hemmvorsprünge (78) ausgebildet sind.

12. Verstelleinheit nach einem der vorhergehenden Ansprüche,
**dadurch gekennzeichnet, dass** Verstelleinheit (14) einen, vorzugsweise als Blattfeder (36) ausgebildeten, Niederhalter (38) zum Führen des Stützelements (32) aufweist.

13. Verstelleinheit nach Anspruch 12,
**dadurch gekennzeichnet, dass** zwischen dem Schieber (40) und dem Niederhalter (38) ein Luftspalt (74) angeordnet ist.

14. Bedienterminal (10), insbesondere für einen Umweltsimulationsschrank (12), mit einer Verstelleinheit (14) nach einem der vorhergehenden Ansprüche,
**dadurch gekennzeichnet, dass**
das erste Klappelement (18) als ein Bedienteil (16) und das zweite Klappelement (22) als ein Basisteil (20) des Bedienterminals (10) ausgebildet ist.

15. Umweltsimulationsschrank (12) mit einem Bedienterminal (10) nach Anspruch 14.
